# EUROPEAN PATENT APPLICATION

(11) **EP 4 790 040 A1**
(43) Date of publication of application: **12.08.2026**
(21) Application number: 24874423.7
(22) Date of filing: 06.09.2024
(51) Int. Cl.: C04B 35/622, B28B 1/30, C04B 35/587, H01L 23/12, H05K 1/03

(54) **GREEN SHEET, METHOD FOR PRODUCING GREEN SHEET, METHOD FOR PRODUCING CERAMIC SUBSTRATE, AND METHOD FOR MEASURING HARDNESS OF GREEN SHEET**

(30) Priority: 05.10.2023 JP 2023173733
(71) Applicant: Niterra Materials Co., Ltd., Yokohama-shi, Kanagawa 235-0032 (JP)
(72) Inventor: SUEMORI, Kazuma, Yokohama-shi, Kanagawa 235-0032 (JP)
(74) Representative: Henkel & Partner mbB
(86) International application number: PCT/JP2024/032080
(87) International publication number: WO 2025/074811

(57) **Abstract**

A green sheet whose hardness is appropriately controlled is provided. The green sheet according to an embodiment includes a ceramic powder. According to the embodiment, a value of a sag value (mm) divided by a thickness (mm) of the green sheet is within a range of not less than 20 and not more than 120, as determined by cutting out a green sheet having a size of 10 mm along a short side×50 mm along a long side, fixing one long-side-direction end portion of the cutout green sheet with a jig, horizontally supporting the cutout green sheet, measuring the sag value of another long-side-direction end portion of the cutout green sheet when 5 seconds have elapsed from removing the horizontal support, and obtaining the value by dividing the sag value by the thickness.

## Description

### [Technical Field]

Embodiments below relate generally to a green sheet, a method for producing a green sheet, a method for producing a ceramic substrate, and a method for measuring a hardness of a green sheet.

### [Background Art]

A ceramic substrate is included in a ceramic circuit board. A semiconductor element is mounted to the ceramic circuit board. A silicon nitride substrate, an aluminum nitride substrate, an aluminum oxide substrate, etc., are used as the ceramic substrate. For example, a silicon nitride substrate is discussed in JP 6293772 (Patent Literature 1). The silicon nitride substrate that is described in Patent Literature 1 has excellent insulative properties, even when thin.

In a production process of a ceramic substrate, a green sheet is prepared by subjecting a ceramic slurry to sheet forming. The ceramic substrate is obtained by dewaxing and firing the prepared green sheet.

A sheet forming process such as a doctor blade technique or the like is used to prepare the green sheet. A long green sheet is obtained in the sheet forming process. After cutting the long green sheet into the desired size, a dewaxing process and a firing process are performed. The dewaxing process and the firing process are processes of heat-treating at prescribed temperatures. There are cases where cracking or chipping occurs in the green sheet when dewaxing and firing are performed.

### [Prior Art Documents]

### [Patent Literature]

Patent Literature 1: JP 6293772

### [Summary of Invention]

### [Problem to be Solved by the Invention]

For example, a green sheet is prepared by mixing a ceramic powder, which is a main component, with a sintering aid powder, a binder, and a solvent. The binder and the solvent are removed in a dewaxing process and in a firing process. Also, a liquid-phase sintering reaction between the ceramic powder and the sintering aid powder, grain growth of the ceramic powder, etc., occur. There are cases where cracking or chipping occur in green sheets in the dewaxing process and the firing process, even though the green sheets used were prepared from the same raw material. As a result of investigating the cause, it was determined that there was fluctuation in the hardness of the green sheets, and that cracking or chipping occurred in the green sheets due to the hardness fluctuation. A typical hardness is, for example, Vickers hardness. An indentation is made when measuring the Vickers hardness. In this measuring method, only a partial hardness is measured at a location at which the indentation was made. Therefore, there is a demand for a measurement method that can appropriately evaluate the hardness in a wider range.

Embodiments address such problems. Embodiments of the invention provide a green sheet of which the hardness is appropriately controlled. Embodiments of the invention also provide a method for producing a green sheet having an appropriate hardness, and a method for producing a ceramic substrate that uses the method for producing the green sheet. Embodiments of the invention also provide a method for measuring a hardness of a green sheet in which the hardness can be appropriately measured in a wider range.

### [Means for Solving the Problem]

A green sheet according to an embodiment includes a ceramic powder. According to the embodiment, a value of a sag value (mm) divided by a thickness (mm) of the green sheet is within a range of not less than 20 and not more than 120, as determined by cutting out a green sheet having a size of 10 mm along a short side×50 mm along a long side, fixing one end portion in a long-side direction of the cutout green sheet with a jig, horizontally supporting the cutout green sheet, measuring the sag value at another long-side-direction end portion when 5 seconds have elapsed from removing the horizontal support, and obtaining the value by dividing the sag value by the thickness.

### [Brief Description of Drawings]

[FIG. 1]

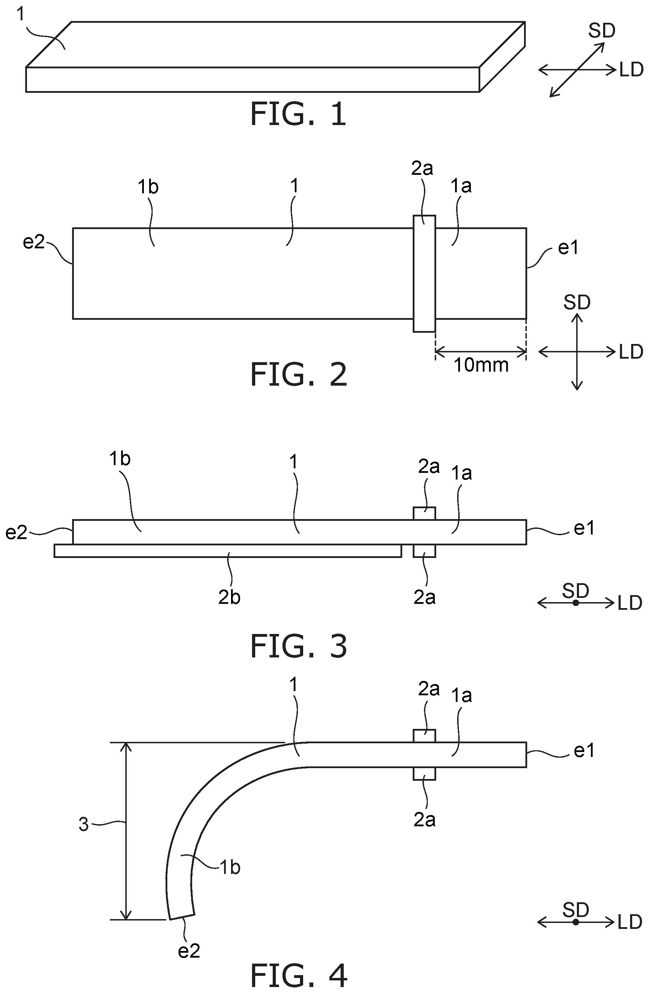

   FIG. 1 is a perspective view showing an example of a green sheet according to an embodiment.
[FIG. 2]
   FIG. 2 is a plan view showing an example in which the green sheet is fixed with a fixing jig.
[FIG. 3]
   FIG. 3 is a side view showing an example in which the green sheet is fixed with the fixing jig.
[FIG. 4]
   FIG. 4 is a side view showing an example of a method for measuring a sag value.
[FIG. 5]

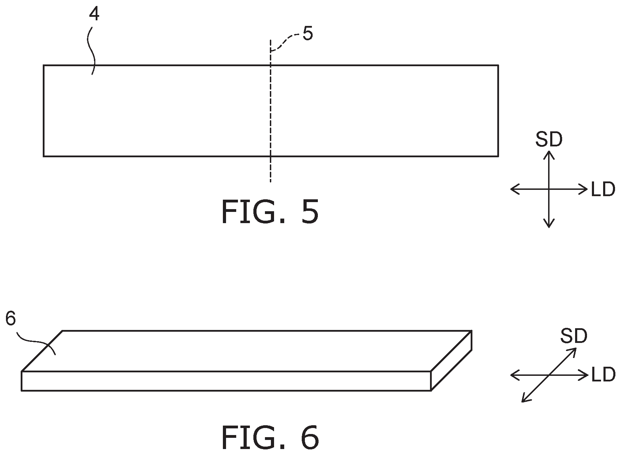

   FIG. 5 is a plan view showing an example of cutting a long green sheet.
[FIG. 6]
   FIG. 6 is a perspective view showing an example of a ceramic substrate according to an embodiment.
[FIG. 7]

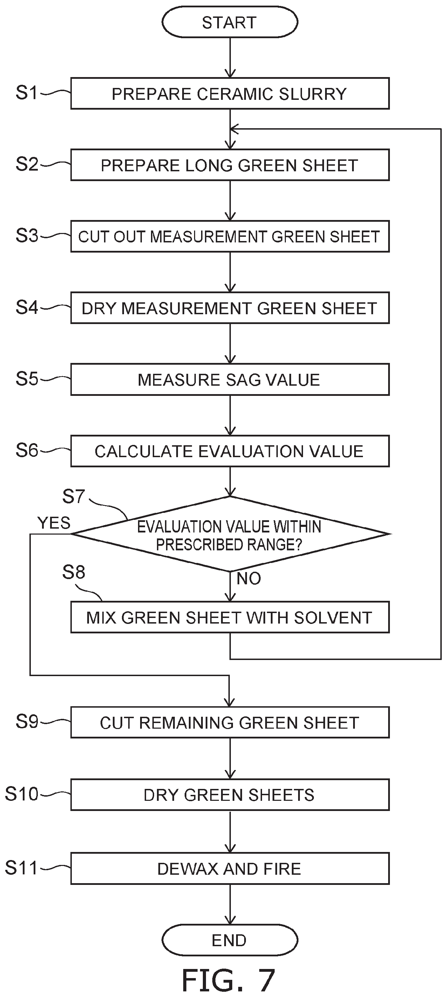

   FIG. 7 is a flowchart showing a specific example of a method for producing a ceramic substrate according to an embodiment.

### [Description of Embodiments]

A green sheet according to an embodiment includes a ceramic powder. According to the embodiment, a value of a sag value (mm) divided by a thickness (mm) of the green sheet is within a range of not less than 20 and not more than 120, as determined by cutting out a green sheet having a size of 10 mm along a short side×50 mm along a long side, fixing one long-side-direction end portion of the cutout green sheet with a jig, horizontally supporting the cutout green sheet, measuring the sag value of another long-side-direction end portion of the cutout green sheet when 5 seconds have elapsed from removing the horizontal support, and obtaining the value by dividing the sag value by the thickness.

FIG. 1 is a perspective view showing an example of a green sheet according to an embodiment. FIGS. 2 and 3 are a plan view and a side view showing an example in which a green sheet is fixed with a fixing jig. FIG. 4 is a side view showing an example of a method for measuring a sag value. In FIGS. 1 to 4, reference numeral 1 is a green sheet, reference numeral 2a is a fixing jig, reference numeral 2b is a support member, and reference numeral 3 is a sag value.

The green sheet 1 includes a ceramic powder. The ceramic powder is the main component of the ceramic substrate. The ceramic substrate is, for example, one selected from a silicon nitride substrate, an aluminum nitride substrate, an aluminum oxide substrate, and a zirconium oxide substrate. The "main component" is the most abundant component in the ceramic substrate. For example, the main component of a silicon nitride substrate is silicon nitride. The main component of an aluminum nitride substrate is aluminum nitride.

The size of the green sheet 1 when measuring the sag value 3 is 10 mm along the short side×50 mm along the long side. The green sheet may be formed with a size of 10 mm along the short side×50 mm along the long side, or may be cut into a size of 10 mm along the short side×50 mm along the long side from a long green sheet. Or, a long green sheet may be cut to obtain green sheets of the target ceramic substrate size, and then the measurement green sheet 1 may be obtained from a green sheet having the substrate size. The green sheet 1 that is used when measuring the sag value 3 also is referred to as the measurement green sheet 1. The measurement of the sag value 3 is performed on the measurement green sheet 1 on which a drying process has been performed. The drying process may be performed on the long green sheet or on the green sheet having the substrate size, or may be performed on the measurement green sheet 1.

Herein, "long green sheet" refers to a sheet that is extremely long compared to a green sheet having the substrate size or a measurement green sheet. There are also cases where a long green sheet may be stored after being wound into a roll shape. As described below, the suitability for mass production can be improved by preparing a long green sheet and by cutting the long green sheet to obtain multiple green sheets having the substrate size.

A method for measuring the sag value 3 will now be described. First, the green sheet 1 that includes a ceramic powder and has a size of 10 mm along the short side×50 mm along the long side is prepared. It is favorable to prepare the green sheet 1 by cutting a long green sheet.

Then, as shown in FIGS. 2 and 3, one end portion 1a in a long-side direction LD of the green sheet 1 is fixed. The location that is fixed is a position 10 mm from an end e1 in the long-side direction LD of the green sheet 1. The fixing jig 2a is used for the fixing. As shown in FIG. 2, the fixing jig 2a is arranged so that an end in the long-side direction LD of the fixing jig 2a is positioned at a location 10 mm from the end e1 of the green sheet 1. The fixing jig 2a is not located in the region up to 10 mm from the end e1 in the long-side direction LD of the green sheet 1. The length in a short-side direction SD of the fixing jig 2a is not less than the length of the short side of the green sheet 1 (10 mm). The width (the length in the long-side direction LD) of the fixing jig 2a is within the range of not less than 1 mm and not more than 5 mm. The fixing jig 2a is located at both the front and back of the green sheet 1. The green sheet 1 is fixed by clamping the green sheet 1 between a pair of fixing jigs 2a.

After being fixed, the green sheet 1 is held horizontally. For example, as shown in FIG. 3, a support member 2b is used to horizontally support another end portion 1b in the long-side direction LD of the green sheet 1. At this time, the green sheet 1 is supported so that the two ends in the long-side direction LD of the green sheet 1 are positioned at the same height.

Subsequently, the support member 2b is moved to remove the horizontal support. Gravity causes the end portion 1b of the green sheet 1 to sag due to the removal of the support. As shown in FIG. 4, the sag value 3 of the other end portion 1b in the long-side direction LD of the green sheet 1 is measured at the timing when 5 seconds have elapsed from the removal of the support. The sag value 3 is represented by the distance in the vertical direction from the upper surface of the fixed end portion 1a to the location of maximum sag of the green sheet 1. The units of the sag value 3 are mm. The measurement efficiency can be increased by using an image sensor, a laser sensor, an ultrasonic sensor, etc., to measure the sag value 3.

The reason for setting the size to be 50 mm along the long side×10 mm along the short side, and for measuring the sag value when 5 seconds have elapsed, is due to suitability for evaluating the hardness of the green sheet. For a typical green sheet, the green sheet will sufficiently deform according to its hardness at the timing when 5 seconds have elapsed. If the elapsed time is excessively long, substantially the entire green sheet will sag, regardless of the hardness of the green sheet. Therefore, the hardness can no longer be appropriately evaluated.

The green sheet 1 according to the embodiment is such that the value obtained by dividing the sag value 3 (mm) by the thickness (mm) of the green sheet 1 is within the range of not less than 20 and not more than 120. In other words, 20 ≤ sag value 3 divided by green sheet 1 thickness ≤ 120. Hereinafter, the value obtained by dividing the sag value 3 by the thickness of the green sheet 1 is referred to as the "evaluation value".

When the evaluation value is within the range of not less than 20 and not more than 120, the hardness relative to the thickness of the green sheet 1 is appropriate. When the hardness relative to the thickness of the green sheet 1 is appropriate, discrepancies such as cracking or chipping of the green sheet 1 in the dewaxing process, cracking or chipping of the ceramic substrate in the firing process, etc., can be suppressed. The thickness is measured at any three locations of the green sheet 1 that is 50 mm along the long side×10 mm along the short side; and the average value is used as the thickness of the green sheet 1.

If the evaluation value is less than 20, the green sheet 1 is hard, which increases the likelihood of cracking when heat treatment is performed. If the evaluation value is greater than 120, the green sheet 1 is too soft, which may reduce the strength of the ceramic substrate. Although cracking or chipping does not easily occur in the production processes of the ceramic substrate, cracking or chipping easily occurs when the ceramic substrate is used. It is therefore favorable for the evaluation value to be within the range of not less than 20 and not more than 120, and more favorably within the range of not less than 20 and not more than 100.

It is favorable for the green sheet that is 10 mm along the short side×50 mm along the long side to be prepared by cutting out from a green sheet that is longer than the green sheet that is 10 mm along the short side×50 mm along the long side. A sheet forming process is used to produce the green sheet. A doctor blade technique, injection molding, die molding, or the like is used as the sheet forming process. Among these, the doctor blade technique is favorable.

In the doctor blade technique, a ceramic slurry is transported by being placed on a carrier. A sheet is formed by adjusting the spacing between a knife edge and the carrier. A film or a belt is used as the carrier. The knife edge also is referred to as a doctor blade. A long green sheet can be produced because the doctor blade technique performs sheet forming while moving the carrier.

The green sheet 1 that is 10 mm along the short side×50 mm along the long side is a sample for measuring (evaluating) the hardness. As a sampling inspection, the green sheet 1 that is 10 mm along the short side×50 mm along the long side can be cut out from the long green sheet; and the hardness of the green sheet 1 can be measured.

FIG. 5 is a plan view showing an example of cutting the long green sheet. In FIG. 5, the reference numeral 4 is a long green sheet, and the reference numeral 5 is a cutting location. In the example shown in FIG. 5, the long green sheet 4 is cut into two at the cutting location 5. The cutting is not limited to the example; and the green sheet 4 may be cut into three or more green sheets 1. Instead of cutting in the long-side direction, the green sheet 4 may be cut in the short-side direction. The green sheet 4 may be cut in both the long-side direction and the short-side direction. Punching may be performed using a die that is 10 mm along the short side×50 mm along the long side.

It is favorable for the thickness of the green sheet 1 to be within the range of not less than 0.1 mm and not more than 2 mm. If the thickness of the green sheet 1 is less than 0.1 mm, the ceramic substrate may be too thin; and insulative properties may degrade. If the thickness of the green sheet 1 is greater than 2 mm, the flexibility of the green sheet 1 may degrade, and the green sheet 1 may not be suited to measuring the sag value. It is therefore favorable for the thickness of the green sheet 1 to be within the range of not less than 0.1 mm and not more than 2 mm, and more favorably within the range of not less than 0.2 mm and not more than 1 mm.

The green sheet is contracted by the firing process. That is, the thickness of the ceramic substrate is less than the thickness of the green sheet. It is favorable for the thickness of the green sheet to be within the range of not less than 1.2 times and not more than 2.0 times the target thickness of the ceramic substrate. Also, it is favorable to adjust the thickness of the green sheet after the drying process as described above. For example, when the target thickness of the ceramic substrate is 0.32 mm, the thickness of the green sheet is adjusted to be within the range of 0.38 to 0.64 mm.

It is favorable for the sag value 3 to be within the range of not less than 10 mm and not more than 40 mm, and more favorably within the range of not less than 20 mm and not more than 35 mm. If the sag value 3 is less than 10 mm, the flexibility of the green sheet 1 is insufficient. If the sag value 3 is greater than 40 mm, the green sheet 1 is too soft.

The ceramic substrate is, for example, one type of substrate selected from a silicon nitride substrate, an aluminum nitride substrate, an aluminum oxide substrate, and a zirconium oxide substrate. In such a case, the main component of the green sheet 1 is one selected from silicon nitride, aluminum nitride, aluminum oxide, and zirconium oxide.

It is favorable for the main component of the green sheet to be silicon nitride. In the firing process of a silicon nitride substrate, silicon nitride changes from the α-phase to the β-phase. Grains of α-silicon nitride have small aspect ratios. On the other hand, grains of β-silicon nitride have large aspect ratios. An aspect ratio change occurs for only silicon nitride among silicon nitride, aluminum nitride, aluminum oxide, and zirconium oxide. The aspect ratio change tends to cause dividing and the like in the dewaxing process and the firing process. In other words, the control of "sag value divided by green sheet thickness" is effective to improve the yield of the silicon nitride substrate.

The green sheet 1 includes one or more selected from the group consisting of a solvent and a binder. It is favorable for the total content of the one or more selected from the group consisting of a solvent and a binder to be within the range of not less than 10 mass% and not more than 40 mass%. The total content is the content after the drying process. For example, the solvent is water or an organic solvent. The binder is an organic binder. The solvent and the binder are mixed with the ceramic powder and the sintering aid powder, and are used to control the fluidity of the slurry. The binder also performs the role of maintaining the shape of the green sheet 1.

If the total content of the solvent and the binder in the green sheet 1 is less than 10 mass%, the flexibility of the green sheet 1 may degrade, and the green sheet 1 may become brittle. If the total content of the solvent and the binder in the green sheet 1 is greater than 40 mass%, the hardness of the green sheet 1 may become insufficient. It is therefore favorable for the total content of the solvent and the binder in the green sheet 1 to be within the range of not less than 10 mass% and not more than 40 mass%, and more favorably within the range of not less than 15 mass% and not more than 35 mass%.

A method for producing the green sheet 1 will now be described. The size of the green sheet 1 for measuring the sag value 3 is standardized to be 10 mm along the short side×50 mm along the long side. On the other hand, the size of the green sheet for producing the ceramic substrate is arbitrary. A long green sheet for producing the ceramic substrate may be prepared, and the green sheet 1 that is 10 mm along the short side×50 mm along the long side may be cut out from the long green sheet.

The method for producing the green sheet according to the embodiment includes a slurry preparation process, a sheet forming process, and a drying process. In the slurry preparation process, a ceramic slurry that includes a ceramic powder, a sintering aid powder, and one or more selected from the group consisting of an organic solvent and a binder is prepared. In the sheet forming process, sheet forming of the ceramic slurry is performed to prepare a green sheet. In the drying process, the green sheet that is prepared is dried.

First, the slurry preparation process is performed. The ceramic powder is the main component of the ceramic substrate. The main component is, for example, one selected from the group consisting of silicon nitride, aluminum nitride, aluminum oxide, and zirconium oxide. The sintering aid powder is, for example, a compound of one or more selected from the group consisting of rare-earth elements, magnesium, titanium, hafnium, tungsten, and molybdenum. The compound is, for example, one or more selected from the group consisting of an oxide, a nitride, a carbide, and a silicide. The rare-earth elements are one or more selected from the group consisting of yttrium and lanthanoid elements.

The solvent is one or more selected from the group consisting of water and an organic solvent. Water and an organic solvent may be mixed and used as the solvent. Multiple organic solvents may be mixed. The ceramic slurry is prepared by mixing a ceramic powder and a sintering aid powder and by adding a solvent or a binder. It is favorable for the total content of the solvent and the binder in the ceramic slurry to be within the range of not less than 15 mass% and not more than 65 mass%. In the drying process that is described below, the total amount of the solvent and the binder in the green sheet is adjusted to be not less than 10 mass% and not more than 40 mass%. Therefore, the added amount of the solvent and the binder in the slurry preparation process is greater than the content of the green sheet after the drying process.

The total content of the solvent and the binder in the green sheet after the drying process can be calculated based on the mass of the green sheet after the drying process and the mass after combusting the green sheet. The solvent and the binder can be removed from the green sheet by combusting the green sheet. The difference between the mass after the drying process and the mass after combusting corresponds to the mass of the solvent and the binder. Or, the solvent and the binder are volatilized by firing the green sheet. For simplicity, the total content of the solvent and the binder in the green sheet after the drying process may be calculated by subtracting the weight of the ceramic substrate (the ceramic sintered body) after firing from the weight of the green sheet after the drying process.

Then, a sheet forming process is performed. A doctor blade technique, injection molding, die molding, or the like is used in the sheet forming process. The doctor blade technique is favorable as the sheet forming process. The doctor blade technique has excellent suitability for mass production. A long green sheet can be obtained by the sheet forming process. "Long green sheet" refers to a green sheet having a larger size than the green sheet 1 for measuring the hardness, which is 10 mm along the short side×50 mm along the long side.

Continuing, the long green sheet that is obtained is cut to the target size. The target size is a size for obtaining a ceramic substrate. Here, a green sheet of the target size is referred to as a "green sheet A". Cutting may not be performed when a die assembly of the target size is used in die molding. In such a case, the green sheet that is obtained by die molding is the "green sheet A".

Then, a drying process of drying the green sheet A is performed. The green sheet after the drying process is referred to as a "green sheet B". It is favorable for the thickness of the green sheet B to be within the range of not less than 0.1 mm and not more than 2 mm. If the thickness of the green sheet B is greater than 2 mm, the ceramic substrate may be thick; and the heat dissipation may degrade. If the thickness of the green sheet B is less than 0.1 mm, the insulative properties of the ceramic substrate may be insufficient. It is therefore favorable for the thickness of the green sheet B to be within the range of not less than 0.1 mm and not more than 2 mm, and more favorably within the range of not less than 0.2 mm and not more than 1 mm.

It is favorable for the total content of the solvent and the binder in the green sheet B to be within the range of not less than 10 mass% and not more than 40 mass%. The solvent and the binder included in the green sheet B are effective in controlling the hardness (the flexibility) of the green sheet.

In the drying process, it is favorable to set the temperature and time of the constant rate drying period and the reduced rate drying period by calculating based on the weight loss behavior of the solvent for each period. The constant rate drying period is a period in which the solvent evaporates at a substantially constant ratio from the green sheet. In the constant rate drying period, the solvent at the surface vicinity of the ceramic compact evaporates. In the reduced rate drying period, the solvent inside the green sheet evaporates. The constant rate drying period and the reduced rate drying period can be discriminated according to the main location from which the solvent is evaporating. The contraction stress applied to the green sheet has a maximum in the transitional period from the constant rate drying period to the reduced rate drying period. The contraction stress helps suppress voids. The control of voids helps control surface unevenness.

It is favorable for the weight reduction rate of the solvent in the constant rate drying period to be not less than 0.2 mass%/min. The upper limit of the weight reduction rate of the solvent in the constant rate drying period is not particularly limited, but is favorably not more than 10 mass%/min. If the weight reduction rate is greater than 10 mass%/min, voids may become large. It is therefore favorable for the weight reduction rate of the solvent in the constant rate drying period to be within the range of not less than 0.2 mass%/min and not more than 10 mass%/min.

The weight reduction rate is calculated by the following method. First, the mass of the green sheet before the drying process is measured. Subsequently, the mass of the green sheet is measured every 2 to 5 minutes while performing the drying process. Also, the period is determined to be either the constant rate drying period or the reduced rate drying period at each timing by checking the location from which the solvent mainly evaporates. The weight reduction rate in each period is calculated based on the mass before the drying process and the mass during the drying process. Or, the drying process may be performed in a state in which the compact is located on a scale. In such a case, the weight reduction rate is calculated by measuring the change amount of the mass in the drying process.

It is favorable for the weight reduction rate of the solvent in the reduced rate drying period to be less than the weight reduction rate of the solvent in the constant rate drying period. It is favorable for the ratio (*R2*/*R1*) of a weight reduction rate R2 of the solvent in the constant rate drying period to a weight reduction rate R1 of the solvent in the reduced rate drying period to be greater than 1 and not more than 20. In the constant rate drying period, evaporation routes of the solvent are formed at the surface vicinity of the compact. By setting the ratio (*R2*/*R1*) to be within the range of greater than 1 and not more than 20, the solvent inside the green sheet can be evaporated in the reduced rate drying period via the evaporation routes. If the ratio (*R2*/*R1*) is greater than 20, the weight reduction rate in the reduced rate drying period is excessively slow, making it highly likely that the solvent inside the green sheet cannot be sufficiently removed. The solvent that remains inside the green sheet may cause large voids. Also, the production efficiency is reduced if the weight reduction rate of the reduced rate drying period is slow. It is favorable for the weight reduction rate of the solvent in the reduced rate drying period to be not less than 0.01 mass%/min but less than 0.2 mass%/min.

The time of the drying process is determined according to the amount of the solvent included in the green sheet. For example, the total content of the solvent and the binder is within the range of not less than 10 mass% and not more than 40 mass% relative to the mass of the mixed powder. In such a case, the drying process is performed so that the weight after the drying process is about 0.6 to 0.9 times the weight before the drying process.

By controlling the weight reduction rate of the solvent in the constant rate drying period and the weight reduction rate of the solvent in the reduced rate drying period, the sag value of the green sheet can be controlled.

The drying process can be performed using various methods such as drying in a drying chamber, drying with a jet nozzle, etc.

The green sheet 1 for measuring the sag value 3, which is 10 mm along the short side×50 mm along the long side, is obtained from the green sheet A or the green sheet B. The drying process is performed on the green sheet 1 when the green sheet 1 is obtained from the green sheet A. The green sheet B may be used as the measurement green sheet 1 when the size of the measurement green sheet 1 and the target substrate size are the same. Or, as described above, the measurement green sheet 1 may be obtained from the long green sheet before the drying process, and then the measurement green sheet 1 may be dried.

The quantity of the green sheet 1 for measuring the sag value 3 is arbitrary. One or more measurement green sheets 1 are obtained from the green sheets formed from one ceramic slurry lot. Or, one or more measurement green sheets 1 per area of 10³ to 10⁷ mm² are acquired. A sampling inspection can be performed by sampling the measurement green sheet 1 from a prescribed amount of green sheets.

By providing a process of measuring the sag value in the production processes of the green sheet, the hardness of the green sheet after drying can be ascertained. In other words, the sag value changes according to the hardness of the green sheet and the thickness of the green sheet. The hardness of the green sheet can be evaluated by using the sag value and the thickness of the green sheet. Also, the green sheet is cut out as a part of the long green sheet, and the sag value of the green sheet is measured, making it possible to evaluate the hardness of the green sheet in a wider range than when an indentation is used to measure the Vickers hardness.

A method for producing a ceramic substrate according to an embodiment will now be described.

According to the method for producing the ceramic substrate according to the embodiment, a dewaxing process and a firing process are performed on the green sheet obtained by the method for producing the green sheet according to the embodiment.

In the dewaxing process, it is favorable to heat the green sheet at a temperature of not less than 400 °C and not more than 800 °C for not less than 1 hour and not more than 4 hours. In the dewaxing process, the greater part of the binder that was added is dewaxed. The atmosphere of the dewaxing process is, for example, air or a nonoxidizing atmosphere. The nonoxidizing atmosphere is a nitrogen gas atmosphere, an argon gas atmosphere, etc.

A firing process is then performed. In the firing process, it is favorable to heat the green sheet in a nonoxidizing atmosphere at a temperature of not less than 1,600 °C and not more than 1,950 °C for not less than 5 hours and not more than 18 hours. It is favorable for the nonoxidizing atmosphere to be a nitrogen gas atmosphere, or a reducing atmosphere including nitrogen gas. Also, it is favorable for the interior of the furnace to be a pressurized atmosphere.

If the green sheet is fired at a low firing temperature of less than 1,600 °C, a dense ceramic substrate may not be obtained. If the firing temperature is greater than 1,950 °C, the grain growth of the ceramic substrate may become excessively large, and the strength may be reduced. When producing a silicon nitride substrate, it is favorable for the firing temperature to be within the range of not less than 1,800 °C and not more than 1,950 °C.

A ceramic substrate can be obtained by performing the firing process. In the dewaxing process and the firing process, the processing object is heated to a high temperature. The sag value (i.e., the hardness) of the green sheet according to the embodiment is controlled, which suppresses the occurrence of cracking or chipping of the ceramic substrate in the dewaxing process and the firing process.

Mainly the solvent is removed in the drying process of the green sheet. Mainly the binder is removed in the dewaxing process. In the firing process, the ceramic substrate is densified by a liquid-phase reaction between the ceramic powder and the sintering aid powder, and by grain growth of the ceramic powder. According to the embodiment, the relative density of the ceramic substrate obtained can be 97% or more. The relative density can be calculated by (actual measured value measured by Archimedes' method/theoretical density)×100%.

The sag value is a value of the green sheet after the drying process. The drying process is the first process in which the solvent is removed. The sag value has a relationship with the homogeneity of the removal of the solvent. The sag value being within the prescribed range indicates that the solvent and the like were homogeneously removed. By homogeneously removing the solvent, the homogeneity of the removal of the binder in the dewaxing process and the homogeneity of the liquid-phase reaction and the like in the firing process can be improved. As a result, the occurrence of cracking or chipping of the ceramic substrate in the dewaxing process and the firing process can be suppressed, and the yield can be increased.

In the firing process, many green sheets are fired at a time. Depending on the size of the furnace, several hundred to several thousand green sheets are fired at a time. By controlling the sag value of the green sheet, the occurrence of cracking or chipping of the ceramic substrate in the firing process can be suppressed.

For example, conventionally, defects (cracking or chipping) of the ceramic substrate are checked, and a production process is performed when the defect ratio is high. The defective ceramic substrates cannot be reused, and are scrapped. In contrast, according to the embodiment, the sag value of the green sheet is measured before firing. For example, a part of the long green sheet is cut; and the sag value of the cut part of the green sheet is measured after drying. Then, when the evaluation value obtained by dividing the sag value 3 by the thickness of the green sheet 1 is within the prescribed range, the remaining green sheets are cut, dried, dewaxed, and fired. By pre-evaluating the green sheets before firing, firing can be avoided for green sheets having a high likelihood of defects. Therefore, an unnecessary firing process is not performed on green sheets that may have defects. Also, only the green sheets that have a low likelihood of defects can be collectively fired in one firing process, which can increase the production efficiency and increase the yield. Also, when the evaluation value is outside the prescribed range, the remaining green sheets can be reused in the process of preparing the ceramic slurry. Green sheets that are in a state before the firing process is performed can be reused as a raw material for preparing green sheets. Waste of raw materials can be reduced, which can increase the production efficiency. Furthermore, the green sheet that is used to measure the sag value may be reused.

FIG. 6 is a perspective view showing an example of a ceramic substrate according to an embodiment. In FIG. 6, the reference numeral 6 is a ceramic substrate. Singulation of the ceramic substrate 6 that is obtained may be performed as necessary. The singulation process is, for example, scribing.

FIG. 7 is a flowchart showing a specific example of a method for producing a ceramic substrate according to an embodiment.

The production method shown in FIG. 7 includes preparing a ceramic slurry including a ceramic powder, a sintering aid powder, and one or more selected from the group consisting of a solvent and a binder (step S1). Sheet forming of the ceramic slurry is performed to prepare a long green sheet (step S2). For example, an extremely long green sheet is prepared in step S2; and the long green sheet is wound into a roll shape and stored. A measurement green sheet for evaluating the hardness is cut out from the long green sheet (step S3). The measurement green sheet is dried (step S4). As described above, it is favorable to control the time and temperature of each of the constant rate drying period and the reduced rate drying period in the drying process. After drying, the sag value of the measurement green sheet is measured (step S5). An evaluation value is calculated by dividing the sag value by the thickness of the green sheet (step S6). It is determined whether or not the evaluation value is within a prescribed range (step S7).

When the evaluation value is outside the prescribed range, the measurement green sheet and the remaining long green sheet may be mixed with a solvent (step S8). As a result, the ceramic slurry is prepared from the green sheet. Step S2 is re-performed using this ceramic slurry. The ceramic slurry that is prepared may be mixed with another ceramic slurry. When dissolving the green sheet with the solvent in step S8, in order to adjust the hardness, the content of the solvent may be different from the mixed amount of the solvent set in step S1 directly previous. For example, when the evaluation value is less than 20, the content of the solvent in step S8 is set to be greater than the content of the solvent in step S1 directly previous. When the evaluation value is less than 120, the content of the solvent in step S8 is set to be less than the content of the solvent in step S1 directly previous. By reusing the green sheet (the ceramic powder and the sintering aid powder), the utilization efficiency of the raw material powder is increased.

When the evaluation value is within the prescribed range, the remaining long green sheet is cut into the substrate size (step S9). The cut green sheet is dried (step S10). In the drying process, similarly to step S3, the time and temperature of each of the constant rate drying period and the reduced rate drying period are controlled. The dried green sheet is dewaxed, and subsequently fired (step S11). The ceramic substrate according to the embodiment is produced by the processes described above.

The order of the processes shown in FIG. 7 is modifiable as appropriate. For example, the green sheet may be cut into the substrate size after step S2. In such a case, each green sheet A that is cut is dried to prepare the green sheet B. A measurement green sheet is cut out from the green sheet B. Or, a measurement green sheet is cut out from the green sheet A and then dried. In either method, the measurement green sheet after drying is prepared, and the sag value is measured. When the evaluation value is within the prescribed range, the other green sheets B are dewaxed and fired.

When a long green sheet that is wound into a roll shape is prepared, the measurement green sheet is most favorably cut out from the long green sheet as shown in FIG. 7. Subsequently, the measurement green sheet is dried, and the evaluation value is calculated. Then, when the evaluation value is within the prescribed range, the remaining green sheet is cut into the substrate size. For example, in another method, the green sheet is cut into the substrate size before measuring the sag value. In such a method, the process of cutting the green sheet is unnecessary when the evaluation value is outside the prescribed range. As shown in FIG. 7, the production efficiency of the ceramic substrate can be increased by measuring the sag value, and then switching between whether or not the green sheet is cut according to the evaluation value.

### (Examples)

### (Examples 1 to 7 and Comparative Examples 1 to 2)

Ceramic slurries were prepared by mixing a ceramic powder, a sintering aid powder, an organic binder, and a solvent. The compositions and the contents were as shown in Table 1. The mixed amounts of the ceramic powder and the sintering aid powder were the values when the total of the ceramic powder and the sintering aid powder was taken to be 100 mass%. The total added amount of the organic binder and the solvent was a value when the total of the ceramic powder, the sintering aid powder, the organic binder, and the solvent was taken to be 100 mass%. Also, the total added amount of the organic binder and the solvent was a value before the drying process.

**[Table 1]**

| | Ceramic powder + sintering aid powder = 100 mass% | | Ceramic powder + sintering aid powder + solvent + binder = 100 mass% |
|---|---|---|---|
| | Ceramic powder (mass%) | Sintering aid powder (mass%) | Total added amount of solvent and binder (mass%) |
| Example 1 | Si₃N₄(93) | Y₂O₃(4) MgO(3) | 21 |
| Example 2 | Si₃N₄(90) | Y₂O₃(4) Er₂O₃(4) MgO(1) TiO₂(1) | 25 |
| Example 3 | Si₃N₄(92) | Y₂O₃(5) MgO(1) TiO₂(2) | 35 |
| Example 4 | Si₃N₄(92.5) | Y₂O₃(6) MgO(1) WO₂(0.5) | 44 |
| Example 5 | AlN(95) | Y₂O₃(5) | 50 |
| Example 6 | Si₃N₄(92) | Y₂O₃(6) MgO(1) TiO₂(1) | 54 |
| Example 7 | Si₃N₄(95) | Y₂O₃(3) MgO(1) TiO₂(1) | 45 |
| Comparative Example 1 | Si₃N₄(93) | Y₂O₃(4) MgO(3) | 8 |
| Comparative Example 2 | Si₃N₄(93) | Y₂O₃(4) MgO(3) | 60 |

Sheet forming was performed by the doctor blade technique using the ceramic slurries according to the Examples and the Comparative Examples. A long green sheet was obtained by sheet forming. Green sheets of the target size were cut from the long green sheet. Subsequently, a drying process was performed. The thickness of the green sheet after performing the drying process and the total content of the binder and the solvent were determined. The thickness of the green sheet was set within the range of not less than 1.2 times and not more than 2.0 times the target thickness of the ceramic substrate.

In the drying process, the weight reduction rate R1 of the solvent in the reduced rate drying period and the weight reduction rate R2 of the solvent in the constant rate drying period were measured. The ratio *R2*/*R1* of the weight reduction rate R2 of the solvent in the constant rate drying period to the weight reduction rate R1 of the solvent in the reduced rate drying period was calculated. The results of the green sheet size, the target thickness of the ceramic substrate, the weight reduction rate R1, and the ratio R2/R1 are shown in Table 2.

**[Table 2]**

| | Green sheet size | | | Drying process | |
|---|---|---|---|---|---|
| | Short side (mm) | Long side (mm) | Target substrate thickness (mm) | R2 (Mass%/min) | Ratio R2/R1 |
| Example 1 | 100 | 120 | 0.25 | 0.4 | 3 |
| Example 2 | 120 | 150 | 0.32 | 0.8 | 5 |
| Example 3 | 80 | 120 | 0.32 | 1.2 | 3 |
| Example 4 | 130 | 160 | 0.635 | 1.7 | 2 |
| Example 5 | 80 | 100 | 0.635 | 2.2 | 5 |
| Example 6 | 150 | 180 | 0.32 | 2.6 | 4 |
| Example 7 | 140 | 120 | 0.25 | 2.7 | 6 |
| Comparative Example 1 | 120 | 150 | 0.32 | 6.8 | 25 |
| Comparative Example 2 | 120 | 150 | 0.32 | 13 | 4 |

In the Examples, the total content of the solvent and the binder in the green sheet after the drying process was within the range of not less than 10 mass% and not more than 40 mass%. In Comparative Example 1, the total content of the solvent and the binder in the green sheet was less than 10 mass%. In Comparative Example 2, the total content of the solvent and the binder in the green sheet was greater than 40 mass%.

A green sheet that was 10 mm along the short side×50 mm along the long side was cut out from the green sheet on which the drying process was performed. The green sheet that was 10 mm along the short side×50 mm along the long side is referred to as the "measurement green sheet".

The measurement green sheet was taken from a green sheet (a green sheet after the drying process) having a thickness within the range of not less than 1.2 times and not more than 2.0 times the target thickness of the ceramic substrate. After drying, four measurement green sheets were taken from each green sheet having a total area of 103 to 10⁷ mm².

The sag value was measured using the measurement green sheet. The size of the fixing jig was 10 mm long×2 mm wide. The measurement green sheet was fixed with the fixing jig at the front and back at a location 10 mm from the end in the long-side direction of the measurement green sheet. The measurement green sheet was placed on a plate and held horizontally. The sag value of the other end of the measurement green sheet was measured at the timing after 5 seconds elapsed after removing the plate. The results are shown in Table 3. Table 3 shows the minimum value and maximum value of the sag values obtained from four green sheets for each Example and each Comparative Example.

**[Table 3]**

| | Sag value (mm) | Sag value (mm)/ Green sheet thickness(mm) | Target substrate thickness(mm) |
|---|---|---|---|
| Example 1 | 26~32 | 68~76 | 0.25 |
| Example 2 | 29~35 | 56~75 | 0.32 |
| Example 3 | 10~17 | 27~31 | 0.32 |
| Example 4 | 19~25 | 21~24 | 0.635 |
| Example 5 | 22~27 | 22~28 | 0.635 |
| Example 6 | 33~36 | 57~84 | 0.32 |
| Example 7 | 32~36 | 100~116 | 0.25 |
| Comparative Example 1 | 2~7 | 5~10 | 0.32 |
| Comparative Example 2 | 42~44 | 122~137 | 0.25 |

For each of the Examples, the evaluation value obtained by dividing the sag value by the thickness of the green sheet was within the range of not less than 20 and not more than 120. For Comparative Example 1, the evaluation value was 5 to 10. This was because the total content of the solvent and the binder in the green sheet was too low. The solvent and binder amounts being low and the green sheet being hard compared to the Examples resulted in the sag value also being low. The evaluation value of Comparative Example 2 was 168. This was because the total content of the solvent and the binder in the green sheet was too high. The solvent and binder amounts were high and the green sheets were soft compared to the Examples, causing the green sheet to elongate and the sag value to become large. The evaluation value was outside the favorable range for each of the Comparative Examples.

Then, the green sheets of the Examples and the Comparative Examples were cut into the substrate size; and a dewaxing process was performed. The temperature of the dewaxing process was set to 500 °C. After the dewaxing process, the occurrence of cracking and chipping of the dewaxed bodies was visually checked. 1,100 dewaxed bodies were prepared for each example. The dewaxed bodies in which cracking or chipping occurred were determined to be defective; and the dewaxed bodies having no cracking or chipping were determined to be good. The defective part occurrence rate was calculated based on the determination results.

Then, 1,000 dewaxed bodies determined to be good were prepared, and a firing process was performed. The temperature of the firing process was set to 1,800 °C. After the firing process, the occurrence of cracking and chipping of the ceramic substrate was visually checked. The ceramic substrates in which cracking or chipping occurred were determined to be defective; and the ceramic substrates having no cracking or chipping were determined to be good. The defective part occurrence rate was calculated based on the determination results. The results are shown in Table 4.

**[Table 4]**

| | Defective part occurrence rate in dewaxing process(%) | Defective part occurrence rate in firing process(%) |
|---|---|---|
| Example 1 | 1 | 2 |
| Example 2 | 0 | 2 |
| Example 3 | 1 | 4 |
| Example 4 | 1 | 2 |
| Example 5 | 1 | 2 |
| Example 6 | 1 | 4 |
| Example 7 | 2 | 4 |
| Comparative Example 1 | 7 | 17 |
| Comparative Example 2 | 4 | 11 |

It can be seen from Table 4 that in the Examples, the occurrence rate of cracking or chipping was suppressed in both the dewaxing process and the firing process. From this result, it can be seen that it was favorable for the value of the sag value 3 divided by the thickness of the green sheet 1 to be within the range of not less than 20 and not more than 120. Also, in Examples 1, 2, 4, and 5 in which the sag value was within the range of not less than 20 mm and not more than 35 mm, the occurrence rate of cracking or chipping was further reduced, and the yield was further improved. Also, as in the Examples, the yield was increased even when the composition or size of the green sheet was changed. It can be seen that control of the sag value was effective to improve the yield of the ceramic substrate.

When the evaluation value was outside the prescribed range as in the Comparative Examples, the occurrence rate of cracking or chipping increased. As a result, the yield decreased.

Embodiments of the invention include the following Features.

### Feature 1

A green sheet including a ceramic powder,
the green sheet being such that a value of a sag value (mm) divided by a thickness (mm) of the green sheet is within a range of not less than 20 and not more than 120, as determined by cutting out a green sheet having a size of 10 mm along a short side×50 mm along a long side, fixing one end portion in a long-side direction of the cutout green sheet with a jig, horizontally supporting the cutout green sheet, measuring the sag value at another long-side-direction end portion of the cutout green sheet when 5 seconds have elapsed from removing the horizontal support, and obtaining the value by dividing the sag value by the thickness.

### Feature 2

The green sheet according to Feature 1, wherein
the thickness is within a range of not less than 0.1 mm and not more than 1 mm.

### Feature 3

The green sheet according to Feature 1 or 2, wherein
the sag value is within a range of not less than 10 mm and not more than 40 mm.

### Feature 4

The green sheet according to any one of Features 1 to 3, wherein
the green sheet includes silicon nitride as a main component.

### Feature 5

The green sheet according to any one of Features 1 to 4, further comprising:
one or more selected from the group consisting of a solvent and a binder,
a total content of the one or more selected from the group being within a range of not less than 10 mass% and not more than 40 mass%.

### Feature 6

A method for producing a green sheet, the method comprising:
preparing a ceramic slurry including a ceramic powder, a sintering aid powder, and one or more selected from the group consisting of a solvent and a binder;
preparing the green sheet by subjecting the ceramic slurry to sheet forming, the green sheet being a ceramic green sheet;
drying the green sheet;
cutting out a part of the green sheet; and
evaluating the green sheet,
the evaluating including
   fixing one end portion in a long-side direction of the part with a jig,
   horizontally supporting another end portion in the long-side direction of the part,
   measuring a sag value (mm) of the other end portion when 5 seconds have elapsed from removing the horizontal support, and
   evaluating the green sheet based on a value obtained by dividing the sag value by a thickness (mm) of the green sheet.

### Feature 7

The method for producing the green sheet according to Feature 6, the method further comprising:
cutting another part of the green sheet into a prescribed size when the evaluating determines the green sheet to be good.

### Feature 8

The method for producing the green sheet according to Feature 6 or 7, wherein
a main component of the green sheet is silicon nitride.

### Feature 9

A method for producing a ceramic substrate, the method comprising:
performing the method for producing the green sheet according to Feature 7; and
dewaxing and firing the cut green sheet.

### Feature 10

The method for producing the ceramic substrate according to Feature 9, wherein
a main component of the green sheet is silicon nitride.

### Feature 11

A method for measuring a hardness of a green sheet, the method comprising:
fixing one end portion in a long-side direction of the green sheet with a jig, the green sheet including a short side and a long side;
horizontally supporting the green sheet; and
measuring a sag value of another end portion in the long-side direction of the green sheet when 5 seconds have elapsed from removing the horizontal support.

### Feature 12

The method for measuring the hardness of the green sheet according to Feature 11, wherein
a length in a short-side direction of the green sheet is 10 mm,
a length in the long-side direction of the green sheet is 50 mm, and
a thickness of the green sheet is not less than 0.1 mm and not more than 1 mm.

### Feature 13

The method for measuring the hardness of the green sheet according to Feature 11 or 12, wherein
a main component of the green sheet is silicon nitride.

### Feature 14

A method for measuring a hardness of a green sheet, the method comprising:
horizontally supporting the green sheet, the green sheet including a ceramic powder and being 10 mm along a short side×50 mm along a long side;
fixing one end portion in a long-side direction of the green sheet with a jig; and
measuring a sag value of another end portion in the long-side direction of the green sheet when the horizontal support is removed.

While certain embodiments of the inventions have been illustrated, these embodiments have been presented by way of example only, and are not intended to limit the scope of the inventions. These novel embodiments may be embodied in a variety of other forms; and various omissions, substitutions, modifications, etc., can be made without departing from the spirit of the inventions. These embodiments and their modifications are within the scope and spirit of the inventions, and are within the scope of the inventions described in the claims and their equivalents. Also, the embodiments above can be implemented in combination with each other.

### [Reference Numeral List]

1 green sheet
2a fixing jig
2b support member
3 sag value
4 long green sheet
5 cutting location
6 ceramic substrate

## Claims

1. A green sheet including a ceramic powder,
the green sheet being such that a value of a sag value (mm) divided by a thickness (mm) of the green sheet is within a range of not less than 20 and not more than 120, as determined by cutting out a green sheet having a size of 10 mm along a short side×50 mm along a long side, fixing one end portion in a long-side direction of the cutout green sheet with a jig, horizontally supporting the cutout green sheet, measuring the sag value at another long-side-direction end portion of the cutout green sheet when 5 seconds have elapsed from removing the horizontal support, and obtaining the value by dividing the sag value by the thickness.

2. The green sheet according to claim 1, wherein
the thickness is within a range of not less than 0.1 mm and not more than 1 mm.

3. The green sheet according to claim 1 or 2, wherein
the sag value is within a range of not less than 10 mm and not more than 40 mm.

4. The green sheet according to claim 1 or 2, wherein
the green sheet includes silicon nitride as a main component.

5. The green sheet according to claim 3, wherein
the green sheet includes silicon nitride as a main component.

6. The green sheet according to claim 1 or 2, further comprising:
one or more selected from the group consisting of a solvent and a binder,
a total content of the one or more selected from the group being within a range of not less than 10 mass% and not more than 40 mass%.

7. The green sheet according to claim 5, further comprising:
one or more selected from the group consisting of a solvent and a binder,
a total content of the one or more selected from the group being within a range of not less than 10 mass% and not more than 40 mass%.

8. A method for producing a green sheet, the method comprising:
preparing a ceramic slurry including a ceramic powder, a sintering aid powder, and one or more selected from the group consisting of a solvent and a binder;
preparing the green sheet by subjecting the ceramic slurry to sheet forming, the green sheet being a ceramic green sheet;
drying the green sheet;
cutting out a part of the green sheet; and
evaluating the green sheet,
the evaluating including
fixing one end portion in a long-side direction of the part with a jig,
horizontally supporting another end portion in the long-side direction of the part,
measuring a sag value (mm) of the other end portion when 5 seconds have elapsed from removing the horizontal support, and
evaluating the green sheet based on a value obtained by dividing the sag value by a thickness (mm) of the green sheet.

9. The method for producing the green sheet according to claim 8, the method further comprising:
cutting another part of the green sheet into a prescribed size when the evaluating determines the green sheet to be good.

10. The method for producing the green sheet according to claim 8 or 9, wherein
a main component of the green sheet is silicon nitride.

11. A method for producing a ceramic substrate, the method comprising:
performing the method for producing the green sheet according to claim 9; and
dewaxing and firing the cut green sheet.

12. The method for producing the ceramic substrate according to claim 11, wherein
a main component of the green sheet is silicon nitride.

13. A method for measuring a hardness of a green sheet, the method comprising:
fixing one end portion in a long-side direction of the green sheet with a jig, the green sheet including a short side and a long side;
horizontally supporting the green sheet; and
measuring a sag value of another end portion in the long-side direction of the green sheet when 5 seconds have elapsed from removing the horizontal support.

14. The method for measuring the hardness of the green sheet according to claim 13, wherein
a length in a short-side direction of the green sheet is 10 mm,
a length in the long-side direction of the green sheet is 50 mm, and
a thickness of the green sheet is not less than 0.1 mm and not more than 1 mm.

15. The method for measuring the hardness of the green sheet according to claim 13 or 14, wherein
a main component of the green sheet is silicon nitride.

16. A method for measuring a hardness of a green sheet, the method comprising:
horizontally supporting the green sheet, the green sheet including a ceramic powder and being 10 mm along a short side×50 mm along a long side;
fixing one end portion in a long-side direction of the green sheet with a jig; and
measuring a sag value of another end portion in the long-side direction of the green sheet when the horizontal support is removed.
